# EUROPEAN PATENT SPECIFICATION

(11) **EP 2 293 663 B1**
(45) Date of publication and mention of the grant of the patent: **14.03.2012**
(21) Application number: 10175648.4
(22) Date of filing: 07.09.2010
(51) Int. Cl.: H05K 13/04, H05K 13/02

(54) **Electronic component feeder**
Beschickungsvorrichtung für elektronische Komponenten
Dispositif d'alimentation de composant électronique

(30) Priority: 07.09.2009 JP 2009205591
(43) Date of publication of application: 09.03.2011
(73) Proprietor: JUKI Corporation, Tama-shi Tokyo 206-8551 (JP)
(72) Inventor: Yamamoto, Yuuji, Tokyo 206-8551 (JP); Yokote, Tamaki, Tokyo 206-8551 (JP); Kuramashi, Daishi, Tokyo 206-8551 (JP)
(74) Representative: Hoeger, Stellrecht & Partner Patentanwälte

(56) References cited:
- EP-A2- 1 534 056
- DE-A1-102006 056 609
- US-A1- 2003 226 873

## Description

The present invention relates to an electronic component feeder for delivering a component housing tape in which a plurality of electronic components is accommodated.

A conventional electronic component mounting apparatus includes a plurality of electronic component feeders which is removably attached to a feeder bank, and a head sucks an electronic component from a predetermined one of the electronic component feeders and transfers the electronic component to a substrate mounting position, thereby carrying out mounting the electronic component.

As the electronic component feeder, generally, an electronic component is fed while a component housing tape accommodating the electronic component is sent out of a reel through a sprocket wheel. The sprocket wheel has an encoder gear formed concentrically and has an origin mark formed in a single place on a circumference of the sprocket wheel. By detecting the encoder gear through an incremental sensor while detecting the origin mark, it is possible to detect an absolute position (a rotating phase) of the sprocket wheel in a rotation, and furthermore, a quantity of delivery of the component housing tape (for example, see Japanese Patent Application Publication No. JP-T-2005-534165).

In the technique described in JP-T-2005-534165, however, it is impossible to recognize the absolute position until the origin mark is detected. For this reason, it is necessary for the sprocket wheel to carry out one rotation at a maximum, thereby detecting the origin mark. Accordingly, it is impossible to detect the absolute position of the sprocket wheel before the origin mark is detected. Therefore, it is impossible to deliver the electronic component with high precision.

In this respect, it is also possible to propose an increase in the origin mark, resulting in an increase in a detection frequency for the absolute position. However, it is impossible to distinguish a circumferential position of each origin mark even if the origin mark is simply increased. It is still impossible to detect the absolute position of the sprocket wheel.

It is an object of the present invention to provide an electronic component feeder capable of delivering an electronic component with higher precision as compared with the conventional art.

According to a first aspect of the present invention, an electronic component feeder includes:
a component housing tape in which sprocket holes and housing portions accommodating electronic components individually are formed in a longitudinal direction of the component housing tape;
a delivering sprocket (211) having teeth to be engaged with the sprocket holes which are formed in a circumferential direction of the delivering sprocket; and
a support member (20a) for pivotally supporting the delivering sprocket rotatably,
wherein the component housing tape is delivered in the longitudinal direction through a rotation of the delivering sprocket,
wherein:
   a phase detecting gear (213) which has a plurality of phase detecting teeth (213a) formed in the circumferential direction, is rotatable integrally with the delivering sprocket and is provided concentrically with the delivering sprocket;
   a gear detecting sensor (218) which is fixed to the support member and detects circumferential positions in one pitch of the phase detecting teeth by detecting the phase detecting teeth;
   a plurality of reference point targets (216) fixed to the delivering sprocket; and
   a target detecting sensor (217) which is fixed to the support member and detects the reference point targets,
   wherein the phase detecting gear and the gear detecting sensor are disposed on an inner peripheral side of the delivering sprocket, and
   wherein the reference point targets are provided in such a manner that the circumferential positions of phase detecting gear in one pitch of the phase detecting teeth detected by the gear detecting sensor when detecting the reference point targets are different from each other.

According to a second aspect of the present invention, the delivering sprocket and the phase detecting gear have the same number of teeth.

According to the first aspect of the invention, the reference point targets are provided in such a manner that the circumferential positions in one pitch of the phase detecting teeth detected by the gear detecting sensor when detecting by the target detecting sensor are different from each other. Therefore, output values of the gear detecting sensor are different from each other in the case in which the reference point targets are detected by the target detecting sensor. By confirming the output value of the gear detecting sensor, consequently, it is possible to decide which one of the reference point targets is detected by the target detecting sensor. In other words, it is possible to identify the circumferential positions of the reference point targets over the delivering sprocket, respectively.
As compared with the conventional art in which a single origin mark is used, therefore, it is possible to detect a rotating phase of the delivering sprocket, and furthermore, a quantity of delivery of the component housing tape more quickly and to deliver the electronic component with higher precision.

Moreover, the phase detecting gear and the gear detecting sensor are disposed on the inner peripheral side of the delivering sprocket. Therefore, it is not necessary to maintain a phase detecting space for the delivering sprocket on an outside. Consequently, it is possible to constitute the compact apparatus.

According to the second aspect of the invention, the delivering sprocket and the phase detecting gear have the same number of teeth. By detecting the phase detecting teeth of the phase detecting gear, therefore, it is possible to directly detect the positions of the teeth in the delivering sprocket without requiring to calculate output values thereof. Accordingly, it is possible to detect the quantity of delivery of the component housing tape with higher precision.

The following description of a preferred embodiment of the present invention serves to explain the invention in greater detail in conjoint with the drawings. These show:
Fig. 1: a perspective view showing an electronic component mounting apparatus including an electronic component feeder according to the invention;
Fig. 2: a side view showing the electronic component feeder;
Fig. 3: a typical view for explaining delivery of an electronic component through the electronic component feeder;
Fig. 4: a left side view showing a tape feeding mechanism;
Fig. 5: a right side view showing the tape feeding mechanism;
Fig. 6: a sectional view showing the tape feeding mechanism;
Figs. 7A and 7B: views for explaining an MR sensor;
Fig. 8: a view for explaining an operation for detecting a quantity of delivery of a component housing tape through the electronic component feeder; and
Fig. 9: a diagram showing waveforms output from a detecting sensor and the MR sensor.

An embodiment according to the invention will be described below in detail.
An electronic component feeder according to the invention is removably provided in an electronic component mounting apparatus and serves to send out a component housing tape accommodating an electronic component to a component feeding position, thereby feeding the electronic component to the electronic component mounting apparatus.

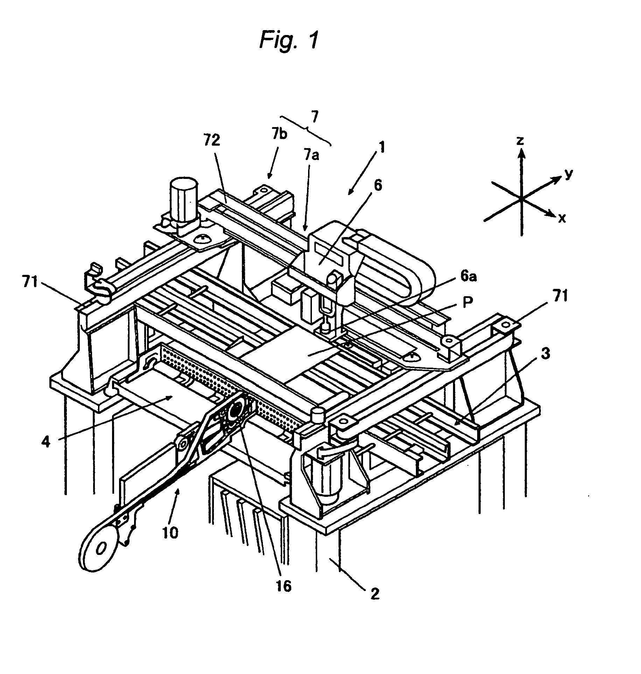

As shown in Fig. 1, two orthogonal directions to each other over a horizontal plane will be referred to as a X-axis direction and a Y-axis direction respectively and a perpendicular direction which is orthogonal thereto will be referred to as a Z-axis direction.

As shown in Fig. 1, an electronic component mounting apparatus 1 includes a base 2 having each component mounted on an upper surface thereof, substrate delivering means 3 for delivering a substrate P from a previous step to a subsequent step in a substrate delivering direction (the X-axis direction), a feeder housing portion 4 having an electronic component feeder 10, a mounting head 6 for mounting, on the substrate P, an electronic component fed by the electronic component feeder 10, and head moving means 7 for moving the mounting head 6 in a direction of each of X and Y axes.

The substrate delivering means 3 has a delivering belt which is not shown, and serves to deliver the substrate P from the previous step side to the subsequent step side in the X-axis direction by means of the delivering belt.
Moreover, the substrate delivering means 3 also serves to stop the delivery of the substrate P in a predetermined component mounting position and to support the substrate P in order to mount the electronic component on the substrate P by means of the mounting head 6.

The feeder housing portion 4 is provided on the base 2. The feeder housing portion 4 is removably provided with a plurality of electronic component feeders 10 in such a manner that the electronic component feeders 10 are arranged with a longitudinal direction thereof set to be orthogonal to the delivering direction of the substrate P.

The mounting head 6 is provided on a beam member 72 which will be described below, and has a predetermined number of sucking nozzles 6a which are protruded downward (in the Z-axis direction). The sucking nozzle 6a is removably provided in such a manner that the sucking nozzle 6a can be exchanged depending on a size or shape of the electronic component to be sucked and held.
The sucking nozzle 6a is connected to air sucking means which is not shown, for example, and vacuum air is caused to pass a through hole (not shown) formed on the sucking nozzle 6a so that the electronic component can be sucked and held in a tip part to be a lower end of the sucking nozzle 6a. Moreover, the air sucking means is provided with an electromagnetic valve which is not shown. A ventilation of the vacuum air can be switched by the electromagnetic valve. Thus, an air sucking state and an atmospheric opening state of the air sucking means are switched.
In other words, the vacuum air is caused to pass the through hole to enable the adsorption of the electronic component when the air sucking state is set, and an inner part of the through hole of the sucking nozzle 6a is brought into an atmospheric pressure state to release the adsorption of the sucked electronic component when the atmospheric opening state is set.

Moreover, the mounting head 6 includes Z-axis moving means (not shown) for moving the sucking nozzle 6a in the Z-axis direction and Z-axis rotating means (not shown) for rotating the sucking nozzle 6a around the Z axis.
The Z-axis moving means (not shown) is provided on the mounting head 6 and serves to move the sucking nozzle 6a in the Z-axis direction. The sucking nozzle 6a is provided on the mounting head 6 movably in the Z-axis direction through the Z-axis moving means. As the Z-axis moving means, for example, it is possible to apply a combination of a servomotor and a belt or a combination of a servomotor and a ball screw.
The Z-axis rotating means (not shown) is provided on the mounting head 6 and serves to rotate the sucking nozzle 6a. The sucking nozzle 6a is provided on the mounting head 6 rotatably around the Z axis through the Z-axis rotating means. For example, the Z-axis rotating means is constituted by an angle regulating motor and an encoder for detecting a rotating angle quantity of the angle regulating motor.

The head moving means 7 is constituted by X-axis moving means 7a for moving the mounting head 6 in the X-axis direction and Y-axis moving means 7b for moving the mounting head 6 in the Y-axis direction.

The X-axis moving means 7a includes a rail-shaped support member (not shown) supported on guide members 71 and 71 provided in a perpendicular direction (the Y-axis direction) to the delivering direction of the substrate P over a substrate delivering path of the substrate delivering means 3 and disposed on a side surface of the beam member 72 extended in the X-axis direction, and driving means (not shown) for moving the mounting head 6 supported on the support member in the X-axis direction. As the driving means, for example, it is possible to apply a combination of a linear motor, a servomotor and a belt or a combination of a servomotor and a ball screw.

The Y-axis moving means 7b includes a rail-shaped support member (not shown) provided on upper surfaces of the guide members 71 and 71 and driving means (not shown) for moving the beam member 72 supported on the support member in the Y-axis direction. As the driving means, for example, it is possible to apply a combination of a linear motor, a servomotor and a belt or a combination of a servomotor and a ball screw.
The beam member 72 is provided movably in the Y-axis direction over the upper surfaces of the guide members 71 and 71 through the Y-axis moving means 7b, and the mounting head 6 is movable in the Y-axis direction through the beam member 72.

The mounting head 6 is moved in the X- and Y-axis directions by the head moving means 7, and furthermore, sucks an electronic component held by a component housing tape A fed to a component feeding position 16 of the electronic component feeder 10 by means of the sucking nozzle 6a of the mounting head 6 and mounts the electronic component on the substrate P in a component mounting position in the substrate delivering means 3.

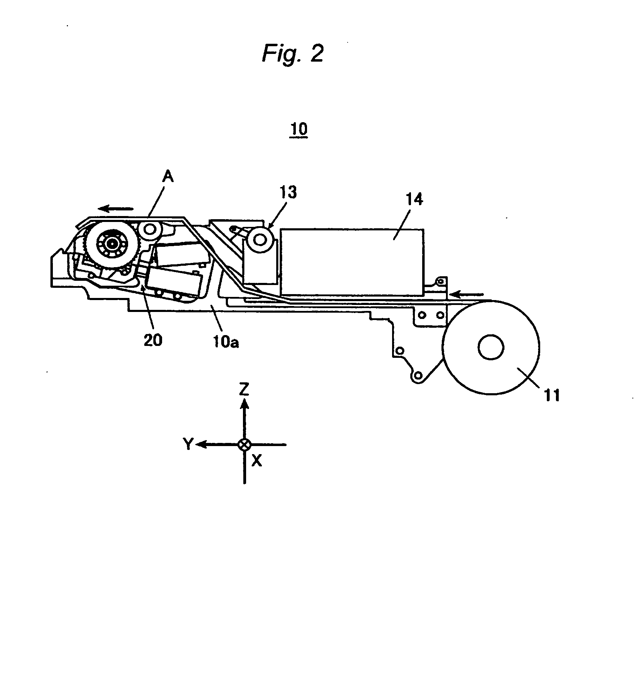

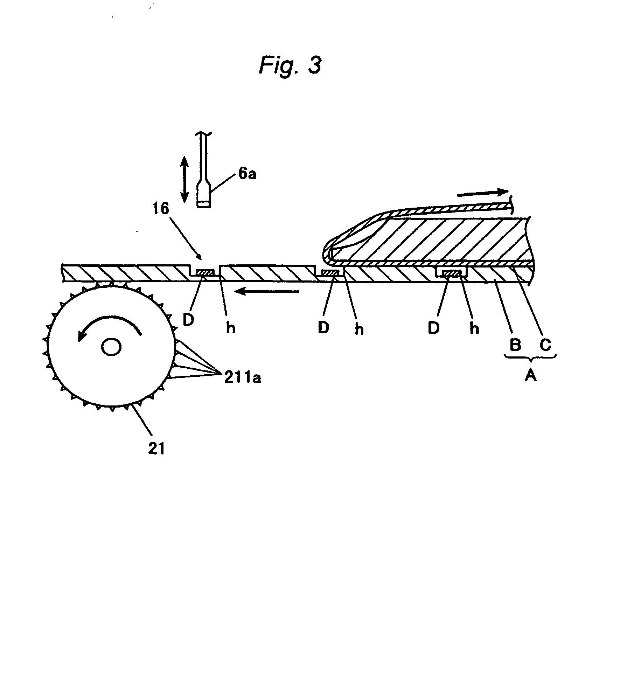

As shown in Fig. 2, the electronic component feeder 10 includes a plate-shaped frame 10a, a reel 11 which is removably set to the frame 10a and around which the component housing tape A having a carrier tape B and a cover tape C (see Fig. 3) is wound, a tape feeding mechanism 20 for feeding the component housing tape A in a delivering direction, a peeling portion 13 for peeling the cover tape C from the carrier tape B, and a collecting portion 14 for collecting the cover tape C peeled by the peeling portion 13.
The electronic component feeder 10 according to the embodiment includes the reel 11 and the tape feeding mechanism 20 on each of left and right in the X direction of the frame 10a, that is, a component delivering path having two lanes, which is not shown. In the case in which the reel 11 or the tape feeding mechanism 20 on the left or right is designated, it is assumed that "R" is attached to the designation when the reel 11 or the tape feeding mechanism 20 which is provided on the right side of the frame 10a in the Y direction is indicated and "L" is attached to the designation when either of them which is provided on the left side of the frame 10a is indicated in the following explanation.

Fig. 3 is a typical view for explaining the delivery of the electronic component through the electronic component feeder 10. As shown in Figs. 2 and 3, the electronic component feeder 10 sends out the component housing tape A wound around the reel 11 in the delivering direction (see an arrow in Fig. 3) by means of a sprocket unit 21 of the tape feeding mechanism 20 and peels the cover tape C from the carrier tape B in the peeling portion 13 in the delivering path. The cover tape C thus peeled is collected into the collecting portion 14. The cover tape C is peeled so that a concave portion h of the carrier tape B is exposed.
The carrier tape B delivers an electronic component D accommodated and held in the concave portion h to the predetermined component feeding position 16, and is then delivered to a portion provided below a body of the electronic component feeder 10 and is discharged to an outside of the electronic component feeder 10.
The electronic component D in the carrier tape B fed to the component feeding position 16 of the electronic component feeder 10 is sucked by the sucking nozzle 6a of the mounting head 6, and is transferred to the substrate P and is thus mounted thereon.

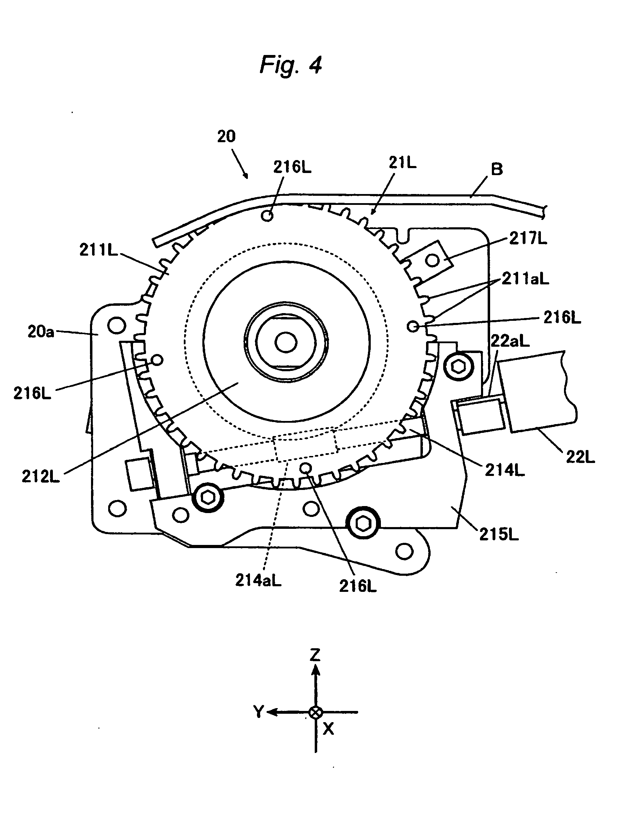

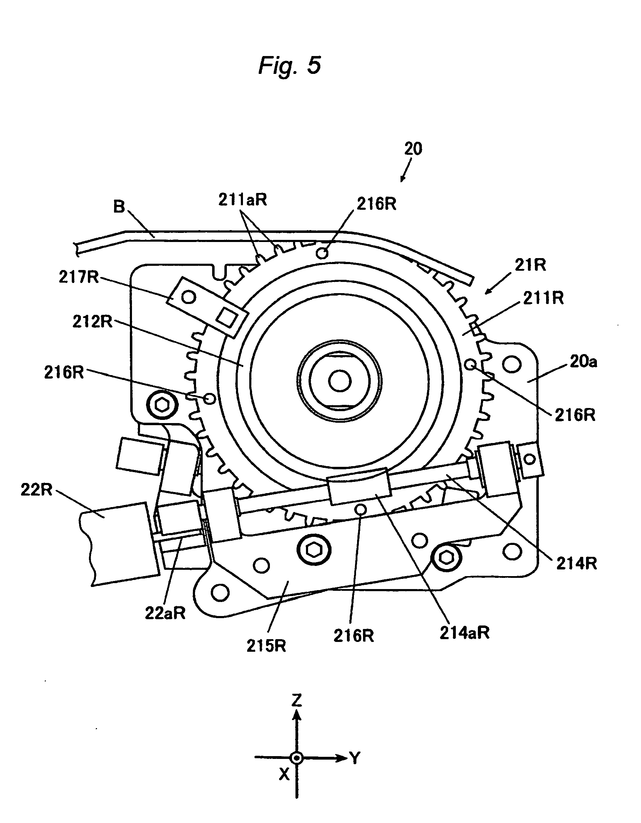

As shown in Figs. 4 to 6, the tape feeding mechanism 20 is fixed to the frame 10a through a center plate 20a, and includes sprocket units 21 L and 21R and driving motors 22L and 22R for rotating and driving the sprocket units 21L and 21R. The sprocket units 21L and 21R and the driving motors 22L and 22R are disposed to make a set on the left and right in the X direction with respect to the frame 10a (the center plate 20a) as described above.

The sprocket units 21L and 21R have sprocket wheels 211L and 211R, worm wheels 212L and 212R and phase detecting gears 213L and 213R which are constituted concentrically and integrally, and furthermore, are pivotally supported on the center plate 20a.

The sprocket wheels 211L and 211R have such a structure that tooth tips of sprockets 211aL and 211aR are engaged with sprocket holes H formed on the component housing tape A (the carrier tape B). Each of the sprockets 211aL and 211aR of the sprocket wheels 211L and 211R according to the embodiment has 45 teeth.

Moreover, four position detecting magnets 216 are buried to be distributed in four equal parts over a circumference in the sprocket wheels 211L and 211 R, respectively. The four position detecting magnets 216L are provided in such a manner that circumferential positions in one pitch of phase detecting teeth 213aL and 213aR to be described below which are formed on the phase detecting gears 213L and 213R are different from each other. In more detail, the four position detecting magnets 216L are disposed to be shifted in order in the circumferential direction by a phase obtained through a division of one pitch between the phase detecting teeth 213aL and 213aR into approximately four equal parts, respectively. The position detecting magnets 216L are detected by a detecting sensor 217 fixed to the center plate 20a.

The worm wheels 212L and 212R are engaged with worm gears 214a formed on gear shafts 214L and 214R, and the gear shafts 214L and 214R are pivotally supported on worm gear housings 215L and 215R which are supported on the center plate 20a. The gear shafts 214L and 214R are engaged with motor shafts 22aL and 22aR of the driving motors 22L and 22R at ends, and a rotating and driving force is transmitted thereto from the driving motors 22R and 22L.
The left and right gear shafts 214L and 214R according to the embodiment are supported at different tilt angles from each other in such a manner that the driving motors 22L and 22R coupled thereto are disposed in different heights, respectively. Consequently, it is possible to avoid an interference of the driving motors 22R and 22L having greater widths than those in other components, thereby setting a width in the X direction to be small.

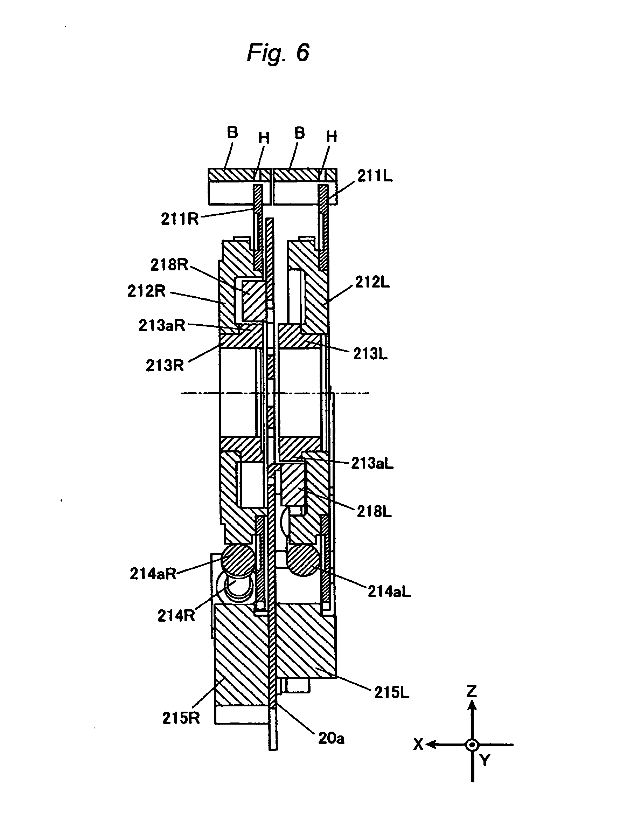

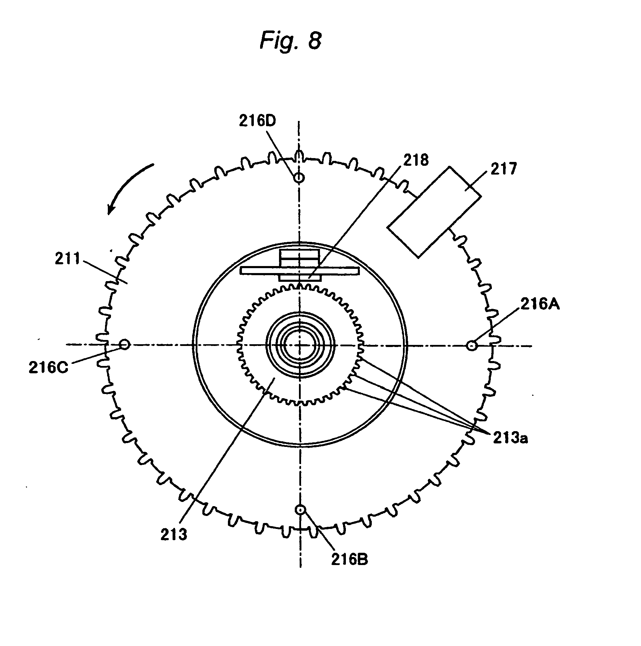

The phase detecting gears 213L and 213R have the phase detecting teeth 213aL and 213aR (see Figs. 6 and 8. They are not shown in the other drawings) which are disposed on an innermost peripheral side of the sprocket unit 21 and are formed outward. The phase detecting teeth 213aL and 213aR have the same number of teeth (45 teeth in the embodiment) as that of the sprockets 211aL and 211aR of the sprocket wheels 211L and 211R and are formed in the same phase of that of the sprockets 211aL and 211aR.

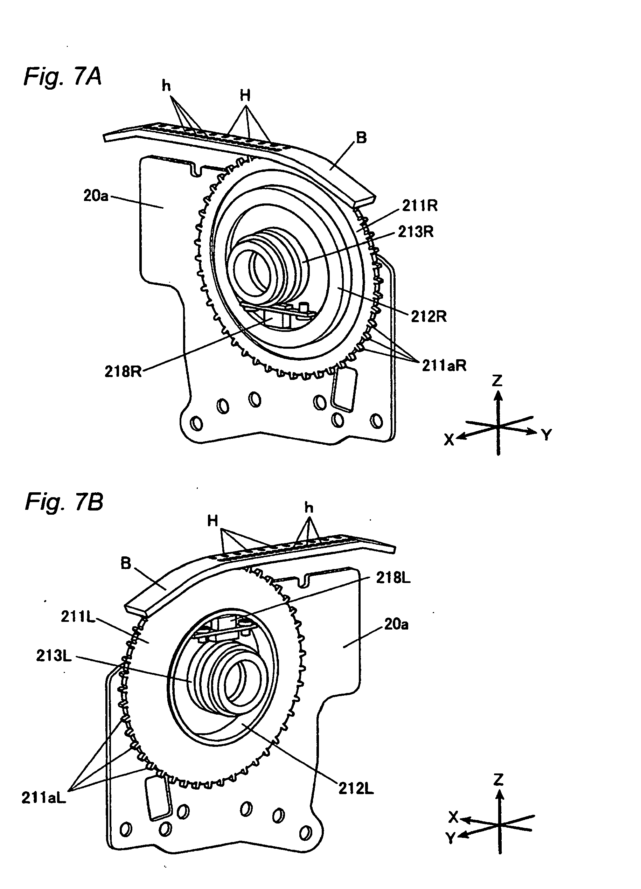

As shown in Figs. 6, 7A and 7B, MR sensors 218L and 218R fixed to the center plate 20a are disposed so as to be opposite to the phase detecting gears 213L and 213R. In more detail, the MR sensors 218L and 218R are provided on an inner peripheral side of the sprocket wheels 211L and 211R with sensor surfaces of the MR sensors 218L and 218R opposed to the phase detecting teeth 213aL and 213aR of the phase detecting gears 213L and 213R. In the embodiment, the MR sensor 218R on a right side is provided below a central axis of the sprocket unit 21 and the MR sensor 218L on a left side is provided above the central axis of the sprocket unit 21.

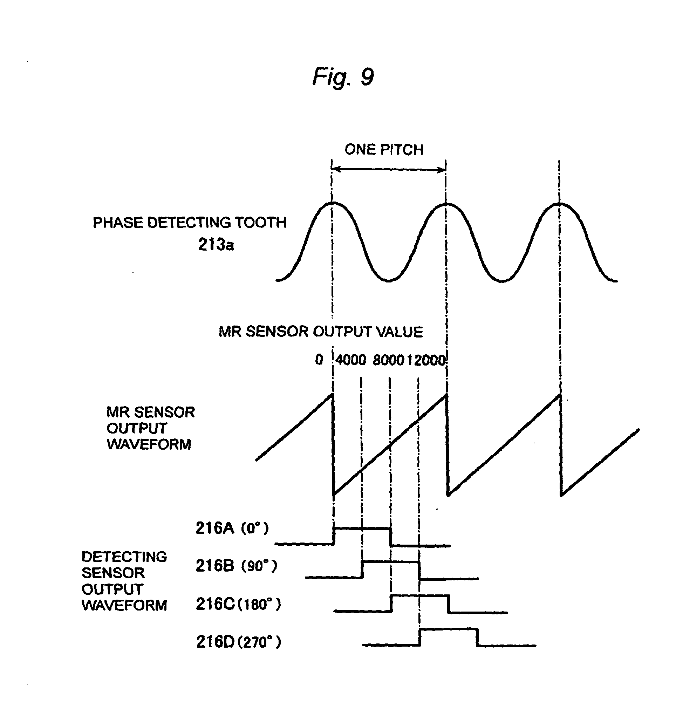

The MR sensors 218L and 218R utilize a magnetoresistive effect of a ferromagnet to change resistance values depending on magnetic field strengths, and output values are varied depending on distances from the phase detecting teeth 213aL and 213aR formed by a magnetic material. Analog outputs from the MR sensors 218L and 218R are A/D converted so that circumferential positions in one pitch of the phase detecting teeth 213aL and 213aR can be detected (see Fig. 9). In the embodiment, output values (0 to 16383) corresponding to 16384 equal parts per pitch of the phase detecting teeth 213aL and 213aR are output.

Next, an operation for detecting a quantity of delivery of the component housing tape A in the electronic component feeder 10 will be mainly described with reference to Figs. 8 and 9.
In the following explanation, it is assumed that the sprocket wheel 211 is rotated in a counterclockwise direction and the four position detecting magnets 216 are indicated as 216A to 216D in a clockwise direction in Fig. 8 respectively.

When the driving motors 22L and 22R are driven to rotate the gear shafts 214L and 214R, the worm wheel 212 is rotated through the worm gear 214a. Consequently, the sprocket wheel 211 and the phase detecting gear 213 which are constituted integrally with the worm wheel 212 are also rotated at the same time.

At this time, the phase detecting tooth 213a of the phase detecting gear 213 passes a detecting range of the MR sensor 218 so that a sawtooth-shaped output waveform is obtained as shown in Fig. 9. When the position detecting magnet 216 passes a detecting range of the detecting sensor 217, moreover, a rectangular output waveform is obtained. From the two output waveforms, it is possible to detect a rotating phase of the sprocket wheel 211.

More specifically, the four position detecting magnets 216 are shifted in the circumferential direction by a phase obtained through a division of one pitch between the phase detecting teeth 213a into approximately four equal parts. Therefore, the circumferential positions in one pitch of the phase detecting teeth 213a of the phase detecting gears 213 which are detected by the MR sensors 218 when the detection carried out through the detecting sensors 217 are different from each other. In other words, the values which are output from the MR sensors 218 and are subjected to the A/D conversion are different from each other in the detection of the four position detecting magnets 216 through the detecting sensors 217.
In the embodiment, the output values of the MR sensors 218 in the detection of the position detecting magnets 216A to 216D are approximately zero, 4000, 8000 and 12000, respectively.

By confirming the output values of the MR sensors 218, accordingly, it is possible to decide which one of the four position detecting magnets 216 passes the detecting sensors 217. Consequently, it is possible to detect the rotating phase of the sprocket wheel 211, and furthermore, the quantity of delivery of the component housing tape A.

As described above, according to the electronic component feeder 10, the output values of the MR sensors 218 in the detection of the four position detecting magnets 216 through the detecting sensors 217 are different from each other. By confirming the output values of the MR sensors 218, consequently, it is possible to decide which one of the four position detecting magnets 216 is detected by the detecting sensors 217. In other words, it is possible to identify the circumferential positions of the four position detecting magnets 216 over the sprocket wheels 211L and 211R, respectively.
As compared with the conventional art in which a single origin mark is used, therefore, it is possible to detect the rotating phases of the sprocket wheels 211L and 211R, and furthermore, the quantity of delivery of the component housing tape A more quickly, thereby delivering the electronic component with higher precision. In the embodiment, it is possible to detect the rotating phases of the sprocket wheels 211L and 211R by simply rotating them at 90° at a maximum.

Moreover, the phase detecting gears 213L and 213R and the MR sensors 218 are disposed on the inner peripheral side of the sprocket wheels 211L and 211R. Therefore, it is not necessary to maintain a phase detecting space for the sprocket wheels 211L and 211R on an outside. Consequently, it is possible to constitute the compact apparatus.

Furthermore, the sprocket wheels 211L and 211R and the phase detecting gears 213L and 213R have the same number of teeth. By detecting the phase detecting teeth 213a of the phase detecting gears 213L and 213R, therefore, it is possible to directly detect the positions of the teeth of the sprocket wheels 211L and 211R without requiring to calculate the output values. Accordingly, it is possible to detect the quantity of delivery of the component housing tape A with higher precision.

The invention should not be limited to the embodiment but it is a matter of course that changes and modifications can be properly made.

For example, although the four position detecting magnets 216 are provided in the embodiment, the number may be two or more.

In addition, the detecting sensor 217 and the position detecting magnet 216 may be a transmission type optical sensor and a detecting slit or a reflection type optical sensor and a detecting reflection plate.

Moreover, the MR sensor 218 may be an optical sensor if it is possible to detect the circumferential positions in one pitch of the phase detecting teeth 213a, for example.

Although the MR sensors 218R and 218L are fixed to the center plate 20a so as to be provided on the lower and upper sides of the central axis of the sprocket unit 21, furthermore, they may be disposed on left and right with respect to the central axis of the sprocket unit 21 or may be disposed with a tilt if respective screws for fixing the MR sensors 218R and 218L do not interfere with each other.

In addition, the worm wheels 212L and 212R may be helical gears.
Moreover, the electronic component feeder 10 does not need to have an integral body formed by two lanes.

## Claims

1. An electronic component feeder comprising:
a component housing tape in which sprocket holes and housing portions accommodating electronic components individually are formed in a longitudinal direction of the component housing tape;
a delivering sprocket (211) having teeth to be engaged with the sprocket holes which are formed in a circumferential direction of the delivering sprocket; and
a support member (20a) for pivotally supporting the delivering sprocket rotatably,
wherein the component housing tape is delivered in the longitudinal direction through a rotation of the delivering sprocket,
wherein:
a phase detecting gear (213) which has a plurality of phase detecting teeth (213a) formed in the circumferential direction, is rotatable integrally with the delivering sprocket and is provided concentrically with the delivering sprocket;
a gear detecting sensor (218) is fixed to the support member and detects circumferential positions in one pitch of the phase detecting teeth by detecting the phase detecting teeth;
a plurality of reference point targets (216) are fixed to the delivering sprocket; and
a target detecting sensor (217) is fixed to the support member and detects the reference point targets,
wherein the phase detecting gear and the gear detecting sensor are disposed on an inner peripheral side of the delivering sprocket, and
wherein the reference point targets are provided in such a manner that the circumferential positions of phase detecting gear in one pitch of the phase detecting teeth detected by the gear detecting sensor when detecting the reference point targets are different from each other.

2. The electronic component feeder according to claim 1, wherein the delivering sprocket and the phase detecting gear have the same number of teeth.

## Patentansprüche

1. Zuführvorrichtung für elektronische Komponenten, umfassend:
ein Komponentengehäuse-Tape, bei welchem Transportlöcher und elektronische Komponenten aufnehmende Gehäusebereiche in einer Längsrichtung des Komponentengehäuse-Tapes individuell gebildet sind;
eine Liefertransportrolle (211) mit mit den Transportlöchern in Eingriff zu bringenden Zähnen, welche in einer Umfangsrichtung der Liefertransportrolle gebildet sind; und
ein Lagerglied (20a) zum rotatorisch drehbaren Lagern der Liefertransportrolle,
wobei die Zulieferung des Komponentengehäuse-Tapes in der Längsrichtung durch eine Rotation der Liefertransportrolle erfolgt,
wobei :
ein Phasendetektionszahnrad (213), welches eine Mehrzahl von in der Umfangsrichtung gebildeten Phasendetektionszähnen (213a) aufweist, mit der Liefertransportrolle integral rotierbar und konzentrisch mit der Liefertransportrolle angeordnet ist;
ein Zahnraddetektionssensor (218) an dem Lagerglied fixiert ist und Umfangspositionen in einer Teilung der Phasendetektionszähne durch Detektieren der Phasendetektionszähne detektiert;
eine Mehrzahl von Referenzpunktzielen (216) an der Liefertransportrolle fixiert sind; und
ein Zieldetektionssensor (217) an dem Lagerglied fixiert ist und die Referenzpunktziele detektiert,
wobei das Phasendetektionszahnrad und der Zahnraddetektionssensor an einer inneren peripheren Seite der Liefertransportrolle angeordnet sind, und
wobei die Referenzpunktziele so bereitgestellt sind, dass die Phasendetektionszahnrad-Umfangspositionen in einer Teilung der Phasendetektionszähne, welche durch den Zahnraddetektionssensor beim Detektieren der Referenzpunktziele detektiert werden, verschieden voneinander sind.

2. Zuführvorrichtung für elektronische Komponenten nach Anspruch 1, wobei die Liefertransportrolle und das Phasendetektierzahnrad die gleiche Anzahl von Zähnen aufweisen.

## Revendications

1. Dispositif d'alimentation de composant électronique comprenant :
un ruban de logement de composant dans lequel des trous de roue à chaîne et des portions de logement logeant des composants électroniques individuellement sont formés dans une direction longitudinale du ruban de logement de composant ;
une roue à chaîne de fourniture (211) comportant des dents à mettre en prise avec les trous de roue à chaîne qui sont formés dans une direction circonférentielle de la roue à chaîne de fourniture ; et
un organe de support (20a) permettant de supporter en pivotement la roue à chaîne de fourniture de façon rotative,
dans lequel le ruban de logement de composant est fourni dans la direction longitudinale par une rotation de la roue à chaîne de fourniture,
dans lequel :
un engrenage de détection de phase (213) qui comporte une pluralité de dents de détection de phase (213a) formée dans la direction circonférentielle, est rotative solidairement avec la roue à chaîne de fourniture et est pourvu concentriquement de la roue à chaîne de fourniture ;
un capteur de détection d'engrenage (218) est fixé à l'organe de support et détecte des positions circonférentielles dans un pas des dents de détection de phase en détectant les dents de détection de phase ;
une pluralité de cibles de point de référence (216) est fixées à la roue de chaîne de fourniture ; et
un capteur de détection de cible (217) est fixé à l'organe de support et détecte les cibles de point de référence ;
dans lequel l'engrenage de détection de phase et le capteur de détection d'engrenage sont disposés sur un côté périphérique interne de la roue à chaîne de fourniture, et
dans lequel des cibles de point de référence sont disposées de telle manière que les positions circonférentielles de l'engrenage de détection de phase dans un pas des dents de détection de phase détecté par le capteur de détection de phase lors de la détection des cibles de point de référence sont différentes les unes des autres.

2. Dispositif d'alimentation de composant électronique selon la revendication 1, dans lequel la roue à chaîne de fourniture et l'engrenage de détection de phase ont le même nombre de dents.
